(19) Europäisches Patentamt
European Patent Office
Office européen des brevets

(11) **EP 2 426 085 B1**

## (12) EUROPÄISCHE PATENTSCHRIFT

(45) Veröffentlichungstag und Bekanntmachung des Hinweises auf die Patenterteilung:
**03.07.2013 Patentblatt 2013/27**

(51) Int Cl.:
*C01B 33/027* *(2006.01)*     *C01B 33/029* *(2006.01)*
*C01B 33/03* *(2006.01)*       *C01B 33/035* *(2006.01)*

(21) Anmeldenummer: **11178373.4**

(22) Anmeldetag: **23.08.2011**

(54) **Verfahren zur Herstellung von polykristallinem Silicium**

Process for producing polycrystalline silicon

Procédé de fabrication de silicium polycristallin

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.09.2010 DE 102010040293**

(43) Veröffentlichungstag der Anmeldung:
**07.03.2012 Patentblatt 2012/10**

(73) Patentinhaber: **Wacker Chemie AG**
**81737 München (DE)**

(72) Erfinder:
• **Hesse, Dr. Karl**
**84489 Burghausen (DE)**

• **Höbold, Wilhelm**
**84547 Emmerting (DE)**
• **Wolf, Reinhard**
**84547 Emmerting (DE)**
• **Häckl, Walter Dr.**
**84367 Zeilarn (DE)**

(74) Vertreter: **Killinger, Andreas et al**
**Wacker Chemie AG**
**Intellectual Property**
**Hanns-Seidel-Platz 4**
**81737 München (DE)**

(56) Entgegenhaltungen:
EP-A1- 2 298 701          EP-A2- 2 033 936
WO-A1-2008/027101         WO-A1-2010/074674
WO-A2-2007/120871         US-A1- 2005 211 901

**Beschreibung**

Gegenstand der Erfindung ist ein Verfahren zur Herstellung von polykristallinem Silicium.

Polykristallines Silicium (kurz: Polysilicium) dient als Ausgangsmaterial bei der Herstellung von einkristallinem Silicium mittels Tiegelziehen (Czochralski- oder CZ-Verfahren)- oder mittels Zonenschmelzen (Floatzone oder FZ-Verfahren). Dieses einkristalline Silicium wird in Scheiben (Wafer) zertrennt und nach einer Vielzahl von mechanischen, chemischen und chemo-mechanischen Bearbeitungen in der Halbleiterindustrie zur Fertigung von elektronischen Bauelementen (Chips) verwendet.

Insbesondere wird aber polykristallines Silicium in verstärktem Maße zur Herstellung von ein- oder multikristallinem Silicium mittels Zieh- oder Gieß-Verfahren benötigt, wobei dieses ein- oder multikristalline Silicium zur Fertigung von Solarzellen für die Photovoltaik dient.

Das polykristalline Silicium, oft auch kurz Polysilicium genannt, wird üblicherweise mittels des Siemens-Prozesses hergestellt. Dabei werden in einem glockenförmigen Reaktor ("Siemens-Reaktor") dünne Filamentstäbe aus Silicium durch direkten Stromdurchgang erhitzt und ein Reaktionsgas enthaltend eine Silicium enthaltende Komponente und Wasserstoff wird eingeleitet.

Daneben ist es auch bekannt, kleine Siliciumpartikel in einem Wirbelschichtreaktor direkt einem solchen Reaktionsgas auszusetzen. Das dabei erzeugte polykristalline Silicium liegt in Form von Granulat vor (Granulat-Poly).

Die Silicium enthaltende Komponente des Reaktionsgases ist in der Regel Monosilan oder ein Halogensilan der allgemeinen Zusammensetzung $SiH_nX_{4-n}$ (n=0, 1, 2, 3; X = Cl, Br, I). Bevorzugt handelt es sich um ein Chlorsilan, besonders bevorzugt um Trichlorsilan. Überwiegend wird $SiH_4$ oder $SiHCl_3$ (Trichlorsilan, TCS) im Gemisch mit Wasserstoff eingesetzt.

Beim Siemens-Prozess stecken die Filamentstäbe üblicherweise senkrecht in am Reaktorboden befindlichen Elektroden, über die der Anschluss an die Stromversorgung erfolgt. Je zwei Filamanentstäbe sind über eine waagrechte Brücke (ebenfalls aus Silicium) gekoppelt und bilden einen Trägerkörper für die Siliciumabscheidung. Durch die Brückenkopplung wird die typische U-Form der auch Dünnstäbe genannten Trägerkörper erzeugt.

An den erhitzten Stäben und der Brücke scheidet sich hochreines Polysilicium ab, wodurch der Stabdurchmesser mit der Zeit anwächst (CVD = Chemical Vapour Deposition / Gasphasenabscheidung).

Einerseits ist man bestrebt, Polysilicium möglichst kostengünstig zu produzieren. Allerdings werden auch die Qualitätsanforderungen seitens der Kunden höher. So ist man andererseits bestrebt, den Anteil von Fremdatomen wie zum Beispiel Kohlenstoff und Dotierstoffen im polykristallinen Silicium möglichst gering zu halten. Die Reinheit der Ausgangsmaterialien wie Chlorsilan und Wasserstoff spielt dabei eine entscheidende Rolle. Dabei wird im Stand der Technik einerseits versucht, diese Ausgangsmaterialien vor der Abscheidung zu reinigen und sie in allen Folgeprozessen vor neuerlichen Verunreinigungen zu schützen.

Die Herstellung von TCS erfolgt üblicherweise durch Reaktion von metallurgischem Silicium mit HCl in einem Wirbelschichtreaktor. Es hat sich gezeigt, dass sich mittels Destillation die Reinheit von TCS erhöhen lässt, vgl. Lee P. Hunt in "Handbook of semiconductor technology", edited by O'Mara, Herring and Hunt, ISBN 0-8155-1237-6, Seite 4, Fig. 2) Dies beruht darauf, dass der Siedepunkt von TCS bei ca. 32 °C (bei Normaldruck) liegt und sich dadurch erheblich von den Siedepunkten der meisten unerwünschten Verunreinigungen und Nebenprodukten wie zum Beispiel Dichlorsilan unterscheidet.

Weiterhin ist bekannt, nach der Abscheidung als Abgas anfallende Stoffe wie Siliciumtetrachlorid (STC) und HCl sowie nicht reagiertes TCS und Wasserstoff zu trennen, zu reinigen und anschließend TCS und Wasserstoff zusammen mit neuem TCS und Wasserstoff wieder der Abscheidung zuzuführen, vgl. Leo. C Rogers in "Handbook of Semiconductor technology", edited by O'Mara, Herring and Hunt, ISBN 0-8155-1237-6, Seite 56, Fig. 6.

Allerdings können Destillationsverfahren nicht alle Probleme lösen, da unerwünschte Stoffe wie iso-Pentan einen ähnlichen Siedepunkt aufweisen wie TCS. Damit ist eine ausreichende Trennung dieser Stoffe von TCS nicht möglich.

In EP 2 033 937 A2 wird ein Verfahren beschrieben, das iso-Pentan mit Chlor bindet, um es so mittels fraktionierter Destillation von TCS besser trennen zu können.

EP 2 036 858 A2 beschreibt die Umwandlung von Bor und Phosphor beinhaltenden Verunreinigungen mit kleinen Mengen an Sauerstoff und aromatischen Aldehyden, um die Siedepunkte der Bor und Phosphor enthaltenden Stoffe zu erhöhen. Anschließend erfolgt Trennung mittels fraktionierter Destillation.

DE 1 667 742 A1 offenbart ein Verfahren zum Reinigen von TCS mittels Destillation, wobei eine Destillationstemperatur verwendet wird, die nur unwesentlich höher ist als der Siedepunkt von TCS.

Auch bei der Abscheidung von Silicium sind Maßnahmen bekannt, unerwünschte Verunreinigungen von Silicium zu vermeiden.

In DE 1 222 481 B wird das Abgas eines ersten Abscheidereaktors anschließend direkt in einen zweiten Abscheidereaktor geleitet. Die zweite Abscheidung weist einen größeren Reinheitsgrad auf.

Um die Ausbeute zu erhöhen, wird beim zweiten Abscheidevorgang zusätzlich hochreiner Wasserstoff zugemischt.

Das in DE 1 222 481 B beschriebene Verfahren ist aber nachteilig, da zwei direkt hintereinander geschaltete Abscheideanlagen nötig sind, die zeitlich synchronisiert werden müssen. Der zusätzliche Bedarf an Frischwasserstoff ist ebenfalls nachteilig.

In US 2008/0056979 A1 werden Abgase aus einem Siemensreaktor in einen Wirbelschichtreaktor geleitet. Die Abgase aus dem Wirbelschichtreaktor können wieder aufbereitet werden. Auch bei diesem Verfahren ist eine Synchronisation der beiden nachgeschalteten Abscheideprozesse erforderlich.

Aus DE 1 147 567 B ist ein Verfahren bekannt, das die Konzentration von Bor im Polysilicium dadurch reduziert, dass mittels des Massenwirkungsgesetzes die Abscheidung von Bor aus $BCl_3$ unterdrückt wird.

Die Reaktion

$$2BCl_3 + 3H_2 \Leftrightarrow 2B + 6HCl$$

soll hierbei in Konkurrenz zu

$$SiHCl_3 + H_2 \Leftrightarrow Si + 3HCl$$

stehen.

Aufgrund des Massenwirkungsgesetzes verschiebt eine kleine HCl-Konzentration das Gleichgewicht nach rechts, was dazu führt, dass weniger Bor abgeschieden wird.

Ein Übergewicht der einen oder der anderen der beiden konkurrierenden Reaktionen wird weiterhin durch die Abscheidetemperatur beeinflusst.

Nachteilig ist, dass die Abscheidetemperatur einen der entscheidenden Prozessparameter bei der Abscheidung darstellt.

Ein Vorgehen wie nach DE 1 147 567 B würde die geeigneten Prozessfenster einschränken und den gesamten Prozess unflexibel machen.

Die Aufgabe der Erfindung bestand darin, ein besonders wirtschaftliches Verfahren zur Herstellung von Polysilicium zur Verfügung zu stellen, das den künftigen Reinheitsansprüchen genügt.

Die Aufgabe wird gelöst durch ein Verfahren nach Anspruch 1.

Wesentlich für das Gelingen der Erfindung ist es, getrennte Wasserstoffkreisläufe für die Abscheidereaktoren vorzusehen und den Wasserstoffkreislauf der ersten Abscheidung derart zu kontrollieren, dass damit der TCS-Fluss der zweiten Abscheidung gesteuert werden kann.

Die Erfinder haben erkannt, dass ein solches Verfahren gegenüber den aus dem Stand der Technik bekannten Prozessen deutlich kostengünstiger ist und gleichzeitig zu einer Reduzierung der Verunreinigungen im Polysilicium führt.

Besonders vorteilhaft ist, dass die wesentlichen Prozessparameter der Abscheidung selbst dadurch nicht beeinflusst werden und das Verfahren somit sehr flexibel und für alle Produktspezifikationen geeignet ist.

Trotz aller Anstrengungen zur Erhöhung der Reinheit der Prozessgasse war es im Stand der Technik nicht möglich, die Qualität des abgeschiedenen Siliciums bezüglich des Fremdstoffanteils merklich zu verbessern.

Erst die Einführung eines kompletten zweiten Abscheidungskreislaufes, der mit gereinigten und kontrollierten Abgasen aus dem ersten Abscheidungskreislaufes betrieben wird, brachte den Durchbruch bzgl. Qualität und Wirtschaftlichkeit.

Das Abgas aus einem ersten Abscheideprozess wird zunächst kondensiert und anschließend mittels Destillation gereinigt, bevor es in einem zweiten Abscheideprozess zum Einsatz kommt.

Die Verfahren des Stands der Technik, die den Abgasstrom aus der ersten Abscheidung direkt in die zweite Abscheidung führen, und die beiden Abscheidereaktoren dazu synchronisieren, weisen neben einen erhöhten Aufwand deutliche Qualitätseinbußen auf.

Erfindungsgemäß wird das Abgas aus dem ersten Abscheideprozess kondensiert. Mittels Destillation wird Siliciumtetrachlorid abgetrennt.

Nicht verbrauchter Wasserstoff wird erfindungsgemäß in einem Kreisprozess nach Reinigung wieder verwendet.

Im Stand der Technik wurde dagegen das Abgas aus dem ersten Abscheideprozess mit hochreinem Wasserstoff verdünnt, bevor es dem zweiten Abscheideprozess zugeführt wird.

Wesentlich für das Gelingen der Erfindung war es, zwei getrennte Wasserstoffkreisläufe für beiden Abscheideprozesse vorzusehen.

Beide Wasserstoffkreisläufe sind stofflich voneinander getrennt.

Das hat den Vorteil, dass der Gesamtwasserstoffverbrauch deutlich reduziert werden kann.

Zum anderen ist sicher gestellt, dass keinerlei Verunreinigungen mittels Wasserstoff in den zweiten Abscheideprozess eingebracht werden.

Die Erfinder haben festgestellt, dass eine bloße Reinigung des Wasserstoffes zur Verwendung für den zweiten Abscheideprozess dazu nicht ausreicht.

Das Verfahren führt zu Polysilicium, das besonders arm an Verunreinigungen ist.

Vorzugsweise sind beide Reaktoren, die im Verfahren zum Einsatz kommen, Siemensreaktoren.

Polysilicium aus dem zweiten Abscheideprozess weist in diesem Fall eine Kohlenstoffkonzentration von kleiner als 1 ppba auf.

Es ist jedoch auch bevorzugt, dass es sich beim zweiten Reaktor um einen Wirbelschichtreaktor handelt.

Granulares Polysilicium aus dem zweiten Abscheideprozess weist eine Kohlenstoffkonzentration von kleiner als 50 ppba auf. Gleichzeitig ist die Chlorkonzentration größer als 5ppmw.

Vorzugsweise wird FTIR (Fourier Transformed InfraRed Absorption) verwendet, um Verunreinigung von substitutionellem Kohlenstoff (Cs) in Silicium zu messen. Eine genaue Beschreibung dieses Verfahrens findet sich in DE 10 2004 014 984 B4. Die Nachweisgrenze für Mehrfachmessungen wird hierbei mit kleiner als 2,9 ppba angegeben. Zusätzlich kann die SEMI Norm F1391 als Beschreibung herangezogen werden.

Wird die Anzahl der Messpunkte erhöht, so kann aus statistischen Gründen die Nachweisgrenze für Mehrfachmessungen mit 1 ppba angegeben werden.

Zu Bestimmung von Verunreinigungen in den Prozessgasen kommt vorzugsweise CRDS zum Einsatz.

Cavity Ring down Spectroscopy (CRDS) ist eine etablierte Methode, kleinste Verunreinigungen in einem Trägergas zu messen.

CRDS misst die Absorptionsrate eines Wellenlängenbereichs und ist damit der klassischen Spektroskopie, die die Absorptionsamplitude misst, im Vorteil, da das Ergebnis gänzlich von der eingestrahlten Amplitude unabhängig ist. CRDS wird in einer Veröffentlichung von Berden, Peeters et al (Int. Reviews in Physical Chemistry, 2000, Vol 19, No. 4 565-607) ausführlich beschrieben.

Diese Messungen werden bevorzugt im Wasserstoffkreislauf eingesetzt.

**Beispiele und Vergleichsbeispiele**

**Vergleichsbeispiel 1**

Nach der Abscheidung von Silicium in einem Siemensprozess wurde ein zweiter Siemensreaktor mit dem aus dem ersten Prozess stammenden Abgas dem heutigen Stand der Technik entsprechend betrieben.

Zusätzlich wurde Wasserstoff in den zweiten Abscheidereaktor zugeführt, um die Ausbeute im zweiten Abscheideprozess zu erhöhen.

Bezüglich Verunreinigungen (insbesondere Kohlenstoff) waren keine Qualitätsverbesserungen zu erkennen. Die Kohlenstoffkonzentration lag bei etwa 5 ppba.

In einem zweiten Versuch dieses ersten Vergleichsbeispiels wurde der zweite Reaktor durch einen Wirbelschichtreaktor ersetzt.

Dabei ergab sich eine Kohlenstoffkonzentration im granularen Polysilicium von etwa 103 ppba.

**Vergleichsbeispiel 2**

Das Verfahren des Vergleichsbeispiels 1 wurde derart abgewandelt, dass das in der ersten Abscheidung entstandene Abgas gereinigt und dann in einem zweiten Siemens-Abscheidereaktor zugeführt wurde.

Auch hier lag der Grad der Kontamination durch Kohlenstoff in beiden Reaktoren auf einem gleichen Niveau (bei etwa 5 ppba).

**Beispiel 1**

Überaschenderweise brachte erst die komplette Trennung der Abscheideprozesse einschließlich der Trennung der Wasserstoffversorgungen den Durchbruch in der gewünschten Qualitätsverbesserung.

Das Verunreinigungsniveau von Kohlenstoff des zweiten Siemens Abscheidereaktors lag unter der Nachweisgrenze von 1 ppba und somit unter 25 % des Vergleichsbeispiels.

Der nachgeschaltete Abscheideprozess liefert demnach Silicium der gewünschten höheren Qualität.

Im Folgenden wird die Erfindung zusätzlich anhand einer Figur erläutert.

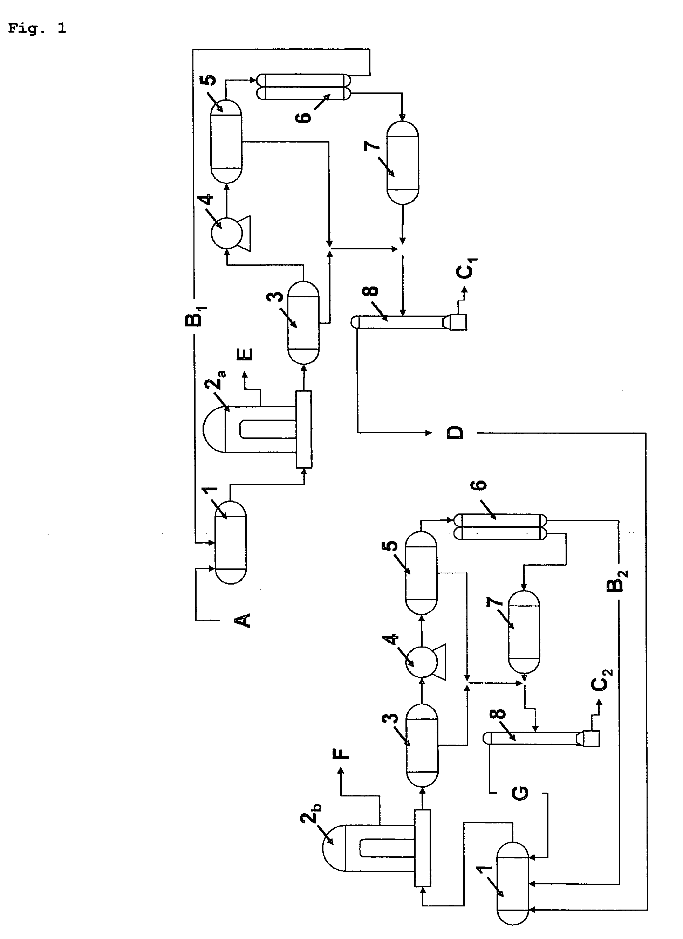

**Fig. 1** zeigt schematisch den Aufbau einer zur Durchführung des Verfahrens geeigneten Vorrichtung.

**Liste der verwendeten Bezugzeichen**

**1** Vorlagetank

**2$_a$, 2$_b$** Siemens- oder Wirbelschichtabscheideanlagen

**3** Kondensattank nach erster Kühlvorrichtung

**4** Verdichter

**5** Kondensattank nach zweiter Kühlvorrichtung

**6** Adsorptionsfilter

**7** Kondensattank nach Adsorption

**8** Vorrichtung zur Destillation

Das bevorzugt zu verwendende Verschaltungsschema umfasst im Wesentlichen zwei stofflich voneinander getrennte Einheiten, einer Vorabscheidung und einer Hauptabscheidung.

Einzige Ausnahme ist die Zuführung von recycletem TCS.

Die erste Einheit (Vorabscheidung) wird gespeist durch den Stoffstrom **A,** der herkömmliches, dem Stand der Technik entsprechend, gereinigtes TCS enthält.

Dieses TCS wird zusammen mit aus der ersten Einheit recycletem Wasserstoff (Stoffstrom **B$_1$**) über einen Vorlagetank **1** einer Abscheideanlage **2$_a$** zugeführt.

Gegebenenfalls kann zusätzlich Frischwasserstoff zugefügt werden.

Das so gewonnene Silicium (Stoffstrom **E**) entspricht dem Stand der Technik.

Das Abgas aus der Abscheideeinrichtung **2$_a$** wird in einer ersten Kühlvorrichtung gekühlt und das Kondensat in einem Kondensattank **3** aufgefangen.

Nach Verdichtung des noch nicht kondensierten Abgases mittels Verdichter **4** wird Kondensat nach einer zweiten Kühlvorrichtung gewonnen und in einem weiteren Kondensattank (5) gesammelt.

Das übrig bleibende Abgas wird über einen Adsorptionsfilter in Wasserstoff und weiteres Kondensat getrennt.

Der Wasserstoff wird über Stoffstrom **B$_1$** der Abscheidung **2$_a$** zugeführt.

Das Kondensat wird in Kondensattank **7** gelagert.

Die Inhalte der Kondensattanks **3, 5** und **7** werden zur Destillationsvorrichtung **8** geführt, in der STC abgetrennt wird, welches über Stoffstrom **C$_1$** entsorgt wird.

In der Destillation aufgereinigtes TCS wird in Stoffstrom **D** einer zweiten Einheit (Hauptabscheidung) zugeführt. Diese zweite Einheit ist mit Ausnahme dieses TCS Stoffstromes stofflich unabhängig von der ersten Einheit.

Die zweite Einheit wird zusätzlich gespeist durch aus dieser Einheit recycletem TCS (Stoffstrom **G**) und recycletem Wasserstoff (Stoffstrom **B$_2$**).

Gegebenenfalls kann vor der Abscheideeinrichtung **2$_b$** zusätzlich Frischwasserstoff zugeführt werden. Das so abgeschiedene Silicium (Stoffstrom F) ist erfindungsgemäß.

Das Abgas aus der Abscheideeinrichtung **2$_b$** wird in einer ersten Kühlvorrichtung gekühlt und das Kondensat in einem Kondensattank **3** aufgefangen.

Nach Verdichtung des noch nicht kondensierten Abgases mittesl Verdichter 4 wird Kondensat nach einer zweiten Kühlvorrichtung gewonnen und in einem weiteren Kondensattank 5 gesammelt.

Das übrig bleibende Abgas wird über einen Adsorptionsfilter **6** in Wasserstoff und weiteres Kondensat getrennt.

Der Wasserstoff wird über Stoffstrom **B$_2$** der Abscheideanlage **2$_b$** zugeführt.

Das Kondensat wird in Kondensattank **7** gelagert.

Die Inhalte der Kondensattanks **3, 5** und **7** werden zur Destillation **8** geführt, in der STC abgetrennt wird, welches über Stoffstrom **C$_2$** entsorgt wird.

In der Destillation aufgereinigtes TCS wird in Stoffstrom **G** einer erneuten Abscheidung zugeführt.

Wenn es sich bei der zweiten Abscheidung in der Abscheideanlage **2$_b$** um eine Granulatabscheidung handelt, was besonders bevorzugt ist, liegt die Konzentration an Kohlenstoff bei etwa 30 ppba oder niedriger und damit auf etwa 30 % des Vergleichswertes.

Die Chlorkonzentration beträgt größer als 5 ppmw (ppmw = Parts Per Million by Weight).

Die Erfindung betrifft damit auch granulares Polysilicium mit einer Kohlenstoffkonzentration von kleiner oder gleich 30 ppba und einer Chlorkonzentration von größer als 5 ppmw.

In den **Tabellen 1** und **2** sind die Ergebnisse der Beispiele und Vergleichsbeispiele zusammengefasst.

**Tabelle 1**

| Polykristallines Silicium aus Siemensprozess | | |
|---|---|---|
| | Kohlenstoff [ppba] | Kohlenstoff [%] |
| Vergleichsbeispiel 1 | 5 | 100 |
| Vergleichsbeispiel 2 | 5 | 100 |
| Beispiel 1 | < 1 | < 25 |
| Beispiel 2 | < 1 | < 25 |

**Tabelle 2**

| Granulares Polysilicium (Wirbelschicht) | | | |
|---|---|---|---|
| | Kohlenstoff [ppba] | Kohlenstoff [%] | Chlor [ppmw] |
| Vergleichs-beispiel 1 | 102 | 100 | 40 |
| Beispiel 1 | 30 | 30 | 30 |

**Beispiel 2**

Überaschenderweise hat sich gezeigt, dass eine einfache Online-Analyse des Wasserstoffkreislaufes nach der Adsorption sehr gut geeignet ist, die Qualität der Abscheidung zumindest qualitativ zu charakterisieren.

Ein Anstieg des Kohlenstoffgehaltes im TCS korreliert zeitlich mit dem Anstieg an Methan im Abgas, gemessen mittels CRDS.

So konnte zum Beispiel eine Erhöhung des Methangehaltes im Wasserstoffkreislaufes mittels CRDS nachgewiesen und so frühzeitig Maßnahmen ausgelöst werden, um die Kohlenstoffkontamination des Siliciums zu verhindern. Als konkreter Auslöser für die Maßnahmen reicht die Messung der relativen Abweichung der gemessenen Verunreinigung (z.B. Methan) von einem zeitlich gebildeten Mittelwert. Wenn beispielsweise das Methanniveau um mehr als 30 % gegenüber einem zeitlichen Mittelwert erhöht ist, werden Maßnahmen eingeleitet.

Die konkreten Maßnahmen bestehen darin, die TCS-Quellen zu wechseln. Hierzu ist es notwendig, dass jede Hauptabscheidung von mehreren Vorabscheidungen über einen Vorlagetank mit TCS gespeist wird.

Jede Vorabscheidung besitzt vorzugsweise eine eigene Messstelle mittels CRDS. Bei jeder Vorabscheidung wird vorzugsweise die Verunreinigung des Wasserstoffs bestimmt.

Der Zulauf an TCS in diesen Tank wird sofort unterbrochen, wenn in der jeweiligen Vorabscheidung der relative gemessene Methanwert eine kritische Grenze (beispielsweise 30% des Mittelwertes) überschreitet.

Das nun überflüssige TCS kann zum Beispiel für die Vorabscheidung verwendet werden.

**Patentansprüche**

**1.** Verfahren zur Herstellung von polykristallinem Silicium, wobei durch Einleiten von Reaktionsgasen enthaltend eine Silicium enthaltende Komponente und Wasserstoff in Reaktoren Silicium abgeschieden wird wobei ein gereinigtes Kondensat aus einem ersten Abscheideprozess in einem ersten Reaktor einem zweiten Reaktor zugeführt wird und bei einem zweiten Abscheideprozess in jenem zweiten Reaktor verwendet wird, **dadurch gekennzeichnet, dass** der erste und der zweite Reaktor jeweils einen separaten Wasserstoffkreislauf umfassen und in den Abscheideprozessen nicht verbrauchter Wasserstoff jeweils gereinigt und den betroffenen Wasserstoffkreislauf zurück geführt wird.

**2.** Verfahren nach Ansprüche 1, wobei einem Abgas des ersten Reaktors Wasserstoff entnommen, dieser auf Verunreinigungen untersucht und die Ergebnisse zur Steuerung der Gasströme im zweiten Reaktor verwendet werden.

3.  Verfahren nach Anspruch 2, wobei Wasserstoff mittels Cavityring-down-Spektroskopie auf Verunreinigungen untersucht wird.

4.  Verfahren nach einem der Ansprüche 1 bis 3, wobei es sich bei beiden Reaktoren um Siemensreaktoren handelt und Silicium auf erhitzten Filamentstäben abgeschieden wird.

5.  Verfahren nach einem der Ansprüche 1 bis 3, wobei es sich beim zweiten Reaktor um einen Wirbelschichtreaktor handelt und dabei granulares polykristallines Silicium abgeschieden wird.

6.  Granulares polykristallines Silicium, **gekennzeichnet durch** eine Kohlenstoffkonzentration von kleiner oder gleich 30 ppba und **durch** eine Chlorkonzentration von größer oder gleich 5 ppmw.

7.  Polykristallines Silicium, **gekennzeichnet durch** einen Kohlenstoffgehalt von kleiner als 1 ppba.


## Claims

1.  Process for producing polycrystalline silicon, by introducing reaction gases comprising a silicon-containing component and hydrogen into reactors to deposit silicon, wherein a purified condensate from a first deposition process in a first reactor is supplied to a second reactor, and is used in a second deposition process in that second reactor, **characterized in that** the first and second reactors each include a separate hydrogen circuit and hydrogen not consumed in the deposition processes is in each case purified and recycled into the relevant hydrogen circuit.

2.  Process according to Claim 1, wherein hydrogen is withdrawn from an offgas of the first reactor, this offgas is analyzed for impurities and the results are used to control the gas flows in the second reactor.

3.  Process according to Claim 2, wherein hydrogen is examined for impurities by means of cavity ring-down spectroscopy.

4.  Process according to any of Claims 1 to 3, wherein both reactors are Siemens reactors and silicon is deposited on heated filament rods.

5.  Process according to any of Claims 1 to 3, wherein the second reactor is a fluidized bed reactor and granular polycrystalline silicon is deposited therein.

6.  Granular polycrystalline silicon, **characterized by** a carbon concentration of less than or equal to 30 ppba and by a chlorine concentration of greater than or equal to 5 ppmw.

7.  Polycrystalline silicon, **characterized by** a carbon content of less than 1 ppba.


## Revendications

1.  Procédé de production de silicium polycristallin, du silicium étant déposé par introduction de gaz de réaction contenant un composant contenant du silicium et d'hydrogène dans des réacteurs, un condensat purifié issu d'un premier procédé de dépôt dans un premier réacteur étant introduit dans un second réacteur et utilisé dans ce second réacteur lors d'un second procédé de dépôt, **caractérisé en ce que** le premier et le second réacteur comprennent chacun un circuit d'hydrogène séparé et l'hydrogène non utilisé dans les procédés de dépôt est à chaque fois purifié et recyclé dans le circuit d'hydrogène correspondant.

2.  Procédé selon la revendication 1, dans lequel de l'hydrogène est extrait d'un gaz d'échappement du premier réacteur, celui-ci est analysé en termes d'impuretés et les résultats sont utilisés pour la régulation des courants gazeux dans le second réacteur.

3.  Procédé selon la revendication 2, dans lequel l'hydrogène est analysé en termes d'impuretés par spectroscopie CRDS (Cavity Ring Down Spectroscopy).

4.  Procédé selon l'une quelconque des revendications 1 à 3, dans lequel les deux réacteurs sont des réacteurs Siemens et le silicium est déposé sur des barreaux filamentaires chauffés.

5. Procédé selon l'une quelconque des revendications 1 à 3, dans lequel le second réacteur est un réacteur à lit fluidisé et du silicium polycristallin granulaire est déposé.

6. Silicium polycristallin granulaire, **caractérisé par** une concentration en carbone inférieure ou égale à 30 ppba et par une concentration en chlore supérieure ou égale à 5 ppm en poids.

7. Silicium polycristallin, **caractérisé par** une teneur en carbone inférieure à 1 ppba.

Fig. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2033937 A2
- EP 2036858 A2
- DE 1667742 A1
- DE 1222481 B
- US 20080056979 A1
- DE 1147567 B
- DE 102004014984 B4

**In der Beschreibung aufgeführte Nicht-Patentliteratur**

- **LEE P. HUNT.** Handbook of semiconductor technology. 4
- **LEO. C ROGERS.** Handbook of Semiconductor technology. 56
- **VON BERDEN, PEETERS et al.** *Int. Reviews in Physical Chemistry,* 2000, vol. 19 (4), 565-607